# EUROPÄISCHE PATENTSCHRIFT

(11) **EP 0 500 976 B1**
(45) Veröffentlichungstag und Bekanntmachung des Hinweises auf die Patenterteilung: **24.04.1996**
(21) Anmeldenummer: 91102843.9
(22) Anmeldetag: 26.02.1991
(51) Int. Cl.: G01R 1/20, H02M 3/335, H01C 3/02

(54) **Anordnung zur Gewinnung einer einem zu messenden Strom proportionalen Spannung**
Device to obtain a voltage proportional to a current to be measured
Dispositif pour l'obtention d'une tension proportionnelle à un courant à mesurer

(43) Veröffentlichungstag der Anmeldung: 02.09.1992
(73) Patentinhaber: SIEMENS AKTIENGESELLSCHAFT, D-80333 München (DE)
(72) Erfinder: Wagner, Franz, W-8000 München 90 (DE)

(56) Entgegenhaltungen:
- CA-A- 1 253 570
- DE-C- 3 405 442
- FR-A- 2 529 374

## Beschreibung

Die Erfindung bezieht sich auf eine wie im Oberbegriff des Patentanspruchs 1 angegebene Anordnung zur Gewinnung einer einem zu messenden Strom proportionalen Spannung.

Eine derartige Anordnung ist bereits aus der DE-B1 28 38 009 bekannt. Die bekannte Anordnung ist durch einen Stromwandler gebildet, der als Stromsensor im Hauptstromkreis eines getakteten Stromversorgungsgerätes liegt. Bei dem Stromversorgungsgerät wird ein im Primärkreis angeordneter Schalttransistor durch einen Taktgeber mit Einschaltimpulsen konstanter Arbeitsfrequenz angesteuert. Zur Regelung der Ausgangsspannung wird der Tastgrad, d.h. der Quotient der Einschaltzeit des Leistungsschalttransistors zur Periodendauer verändert. Ferner wird der Schalttransistor gesperrt, sobald der gemessene Momentanwert des durch den Schalttransistor fließenden Stromes einen vorgegebenen Grenzwert übersteigt.

Der bekannte Umrichter enthält zu diesem Zweck eine Strombegrenzungsschaltung mit einem Stromwandler als Stromerfassungsvorrichtung. Dieser Stromerfassungsvorrichtung ist ein RC-Filter als Tiefpaß nachgeschaltet, so daß die Bürdenspannung von Einschaltstromspitzen befreit wird. Auf diese Weise wird vermieden, daß die Sperrung des Schalttransistors fälschlicherweise vorzeitig durch die Einschaltstromspitze ausgelöst wird.

Allerdings kann das RC-Glied nur für einen bestimmten Strom optimal dimensioniert werden. Die Verwendung eines derartigen Tiefpasses führt daher nur bei vergleichsweise kleinen Strombereichen zum gewünschten Ergebnis.

Man kann andererseits als Stromerfassungsvorrichtung einen Meßwiderstand oder Shunt vorsehen, dessen Spannungsabfall ein Maß für den durch den Widerstand fließenden Strom ist. Da Meßwiderstände eine gewisse Länge haben, kann in vielen Fällen, insbesondere bei hohen Stromanstiegsgeschwindigkeiten, der unvermeidliche induktive Anteil des Spannungsabfalles zu erheblichen Verfälschungen des Stromabbildes führen. Dies kann sich selbst bei ebenen Folienwiderständen, die wegen ihres kleinen Verhältnisses von Länge zu Breite ohnehin eine vergleichsweise niedrige Induktivität besitzen, als sehr störend erweisen.

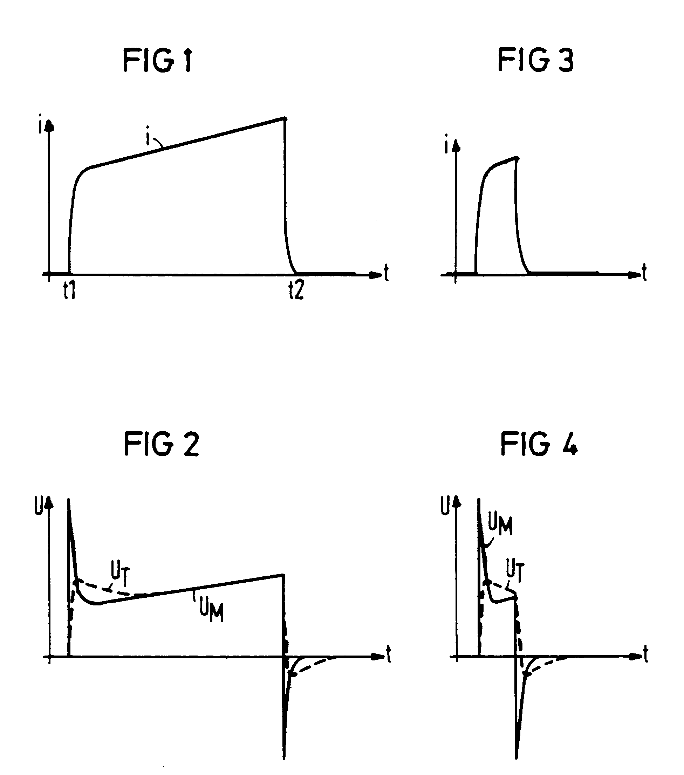

Die Verfälschung des Stromabbildes äußert sich im Falle eines impulsförmigen Stromes im wesentlichen durch eine deutliche kurzzeitig Spannungsüberhöhung an den Stromflanken. Dieser Sachverhalt ist in den Figuren 1 und 2 dargestellt.

Ein getreues Abbild des erfaßten Stromes ist insbesondere bei getakteten Stromversorgungsgeräten mit Momentanwertstrombegrenzung oder Current-Mode-Regelung von großer Bedeutung. Ein getreues Abbild des Stromes ist z.B. auch dann von Interesse, wenn eine aus einem Strom gewonnene Spannung, z.B. mit Hilfe eines Oszillographen zur Anzeige gebracht werden soll.

Man kann bei höheren Strömen Stromwandler einsetzen, die bei entsprechender Messung ein brauchbares Abbild des Primärstromes liefern können. Derartige Stromwandler sind jedoch mit einem vergleichsweise großen Aufwand verbunden. Kappt man, insbesondere bei Verwendung eines Strommeßwiderstandes, die Spitzen im Stromabbild, d.h. die Spitzen der aus dem impulsförmigen Strom gewonnenen impulsförmigen Spannung durch einen nachgeschalteten RC-Tiefpaß, so muß unter Umständen eine so große Zeitkonstante in Kauf genommen werden, daß die Verfälschung, insbesondere bei kleinem Tastgrad, praktisch während des ganzen Strompulses andauert. Die Figuren 1 und 2 zeigen einen solchen Fall.

Aufgabe der Erfindung ist es, eine wie Oberbegriff des Patentanspruchs 1 angegebene Anordnung zur Gewinnung einer einem zu messenden Strom proportionalen Spannung derart auszubilden, daß die Wechselspannung ein möglichst getreues Abbild des Stromes ist.

Insbesondere soll die Anordnung für getaktete Stromversorgungsgeräte mit Strombegrenzung oder Current-Mode-Regelung geeignet sein, bei denen mit Hilfe der Anordnung aus einer Folge unipolarer Rechteckimpulse eine impulsförmige Spannung zu gewinnen ist.

Überlegungen im Rahmen der Erfindung haben ergeben, daß sich der induktive Spannungsabfall des Meßwiderstandes durch eine gegengerichtete, annähernd identische Spannung kompensieren läßt.

Gemäß der Erfindung wird die Anordnung der eingangs genannten Art in der im kennzeichnenden Teil des Patentanspruchs 1 angegebenen Weise ausgebildet.

Durch diese Maßnahmen ergibt sich in vorteilhafter Weise eine Anordnung, bei der sich die unvermeidliche Induktivität eines Meßwiderstandes bei der Gewinnung eines Stromabbildes in besonders geringem Maße auswirkt. In Verbindung mit einem getakteten Stromversorgungsgerät ergibt sich der besondere Vorteil, daß sich ein der Anordnung nachgeschalteter Tiefpaß ohne weiteres so dimensionieren läßt, daß keine erhebliche Verfälschung des Signals mehr auftritt.

Vorteilhafte Weiterbildungen der Erfindung ergeben sich aus den Ansprüchen 2 bis 7.

Die Erfindung wird anhand der in den Figuren 1 und 3 gezeigten Stromdiagramme, der in Figur 2 und 4 gezeigten Spannungsdiagramme sowie der in den Figuren 5 bis 11 gezeigten Ausführungsbeispiele näher erläutert.

Es zeigen
- Fig. 1: den zeitlichen Verlauf eines nahezu rechteckförmigen Stromimpulses relativ langer Dauer,
- Fig. 2: die zum Strom nach Fig. 1 gehörende Meßspannung vor und hinter einem Tiefpaß,
- Fig. 3: einen nahezu rechteckförmigen Stromimpuls relativ kurzer Dauer,
- Fig. 4: die zum Strom nach Fig. 3 gehörende Meßspannung vor und hinter einem Tiefpaß,
- Fig. 5: eine Anordnung mit einem quaderförmigen, liegend auf einer Leiterplatte angeordneten Widerstandsbauteil,
- Fig. 6: einen Stromlauf für die Anordnung nach Fig. 5,
- Fig. 7: eine Anordnung mit zwei stehend auf einer Leiterplatte angeordneten Widerständen mit dazwischen angeordnetem Blechteil,
- Fig. 8: einen Stromlauf für die Anordnung nach Fig. 7,
- Fig. 9: eine Anordnung mit drei stehend auf einer Leiterplatte angeordneten Widerstandsbauteilen,
- Fig. 10: einen Stromlauf für die Anordnung nach Fig. 9 und
- Fig. 11: einen Stromlauf für ein getaktetes Stromversorgungsgerät.

Fig. 1 zeigt den zeitlichen Verlauf eines durch einen Shunt fließenden Stromes i. Zum Zeitpunkt t1 springt der Strom vom Wert 0 auf einen Anfangswert. Ausgehend von diesem Anfangswert steigt der Strom i rampenförmig bis zum Zeitpunkt t2 an. Zum Zeitpunkt t2 sinkt der Strom auf den Wert 0 ab.

Der in Fig. 3 gezeigte Stromimpuls unterscheidet sich von den nach Fig. 1 dadurch, daß der Zeitbereich, in dem der Strom rampenförmig ansteigt, von wesentlich geringerer Dauer ist.

Fig. 2 zeigt den zeitlichen Verlauf der Meßspannung, die mit Hilfe einer Anordnung zur Stromerfassung aus dem in Fig. 1 gezeigten Strom gewonnen wird. Auffällig sind die zur Anstiegsflanke des Stromimpulses gehörende positive Spannungsspitze und die zur Abstiegsflanke des Stromimpulses gehörende negative Spannungsspitze. Die mit Hilfe eines Tiefpasses aus der Meßspannung U_{M} gewonnene korrigierte Meßspannung U_{T} ist strichliert dargestellt. Wie die strichlierte Darstellung zeigt, sind die Spannungsspitzen deutlich verringert. Dies wird allerdings damit erkauft, daß die Spannung am Ausgang des Tiefpasses nur gegen Ende des Impulses dem rampenförmig ansteigenden Verlauf des Stromimpulses entspricht. Wie aus Fig. 4 hervorgeht, kann die Verfälschung der Meßspannung durch den Tiefpaß im Falle eines vergleichsweise kurzen Stromimpulses während der gesamten Impulsdauer fortbestehen. Im Beispiel nach den Figuren 3 und 4 wird sogar aus dem rampenförmigen Anstieg des Stromes ein rampenförmiger Abfall der korrigierten Meßspannung.

Derartige Verhältnisse sind insbesondere dann nicht tragbar, wenn die Anordnung zur Gewinnung einer einem zu messenden Strom proportionalen Spannung Bestandtteil der Stromerfassungsvorrichtung eines getakteten Stromversorgungsgerätes mit Strombegrenzung oder Current-Mode-Regelung ist. Insbesondere für eine Current-Mode-Regelung ist ein getreues Abbild des Primärstromes von wesentlicher Bedeutung.

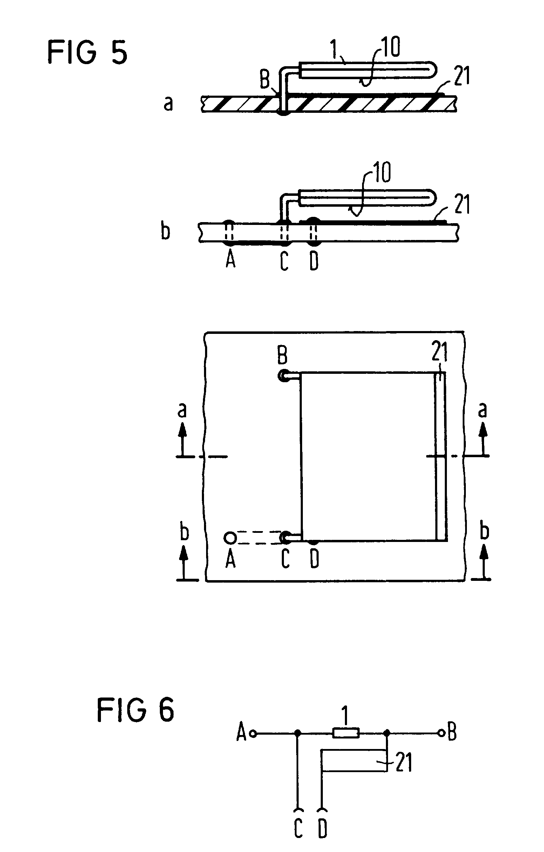

Die in den Figuren 5 bis 10 gezeigten Anordnungen gestatten es, die genannten Schwierigkeiten bei der Stromerfassung wirksam zu vermeiden. Die Anordnungen sehen als Widerstandsbauteil jeweils einen sogenannten Folienwiderstand vor, bei dem ein Träger von quaderförmiger Gestalt eine ebene, flächenhafte Widerstandsschicht in Form einer Folie aus Widerstandsmaterial trägt. Der Träger besteht wenigstens an seiner Oberfläche aus elektrisch isolierendem Material. Die Oberfläche des Folienwiderstandes ist mit einer ebenfalls isolierenden Schutzschicht überzogen.

Aneinander gegenüberliegenden Enden der Widerstandsschicht 10 sind die Anschlüsse A und B für den abzubildenden Wechselstrom vorgesehen. Räumlich parallel zur Widerstandsschicht ist jeweils eine flächenhafte Zuleitungsschicht angeordnet. Die Widerstandsschicht und die Zuleitungsschicht sind an einer ihrer Stirnseiten elektrisch miteinander verbunden. An den dieser elektrischen Verbindung gegenüberliegenden Stirnseiten der beiden Schichten und sind die Anschlüsse C und D für die bei der Stromabbildung gewonnene Wechselspannung angeordnet.

Bei der Anordnung nach Fig. 5 ist die Widerstandsschicht Teil eines quaderförmigen, liegend auf einer Leiterplatte 4 angeordneten Folienwiderstandes. Die Zuleitungsschicht ist Teil der Kaschierung 21 der Leiterplatte 4, die den Folienwiderstand 1 trägt. Dabei ist eine flächige Rückführung der Meßspannung über eine Leiterplatte vorgesehen. Der normalerweise stehende Folienwiderstand ist an seinen Anschlüssen um 90° gebogen und liegend eingelötet. Die Rückführung der Meßspannung erfolgt flächig auf der Leiterplatte an der Stelle, an der der Folienwiderstand angeordnet ist. Durch die flächige Rückführung der Meßleitung über die parallel zum Folienwiderstand liegende Kupferfläche auf der Leiterplatte wird das Stromabbild der Meßspannung wirksam verbessert.

Fig. 6 zeigt einen Stromlauf für die Anordnung nach Fig. 5.

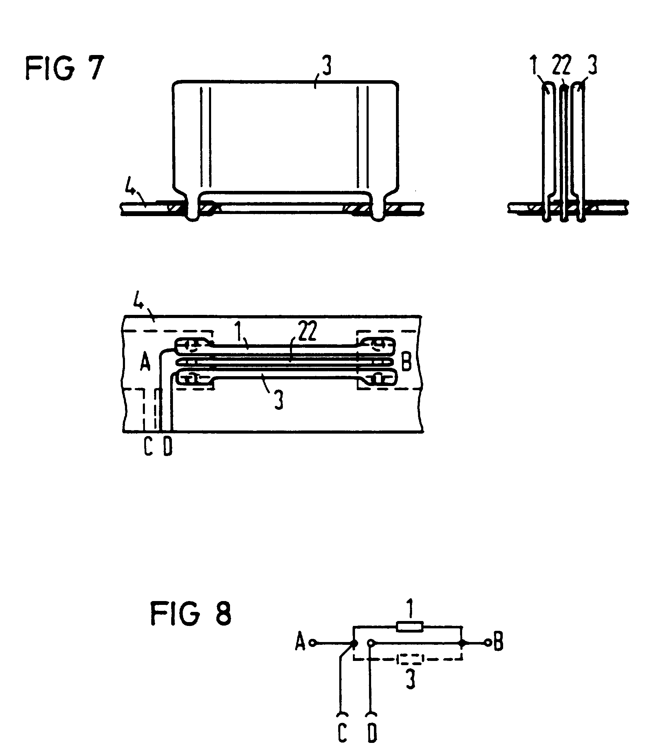

Bei der Anordnung nach Fig. 7 ist die Widerstandsschicht Teil eines quaderförmigen, stehend auf einer Leiterplatte 4 angeordneten Folienwiderstandes 1. Die Zuleitungsschicht ist ein ebenfalls stehend auf der Leiterplatte 4 angeordnetes metallenes Blechteil 22. Dieses Blechteil 22 ist als Stützblech ausgebildet, das vorzugsweise aus Kupfer besteht. Die Anordnung weist daher eine flächige Rückführung der Meßspannung über das Blechteil 22 auf. Der Folienwiderstand ist wie üblich stehend montiert. Die Rückführung der Meßspannung erfolgt mit einem Blechteil, dessen Größe und Form der des Folienwiderstandes weitgehend entspricht. Der Leiter ist parallel zum Folienwiderstand in einer möglichst engen Position zum Folienwiderstand angeordnet.

Fig. 8 zeigt einen Stromlauf für die Anordnung nach Fig. 7.

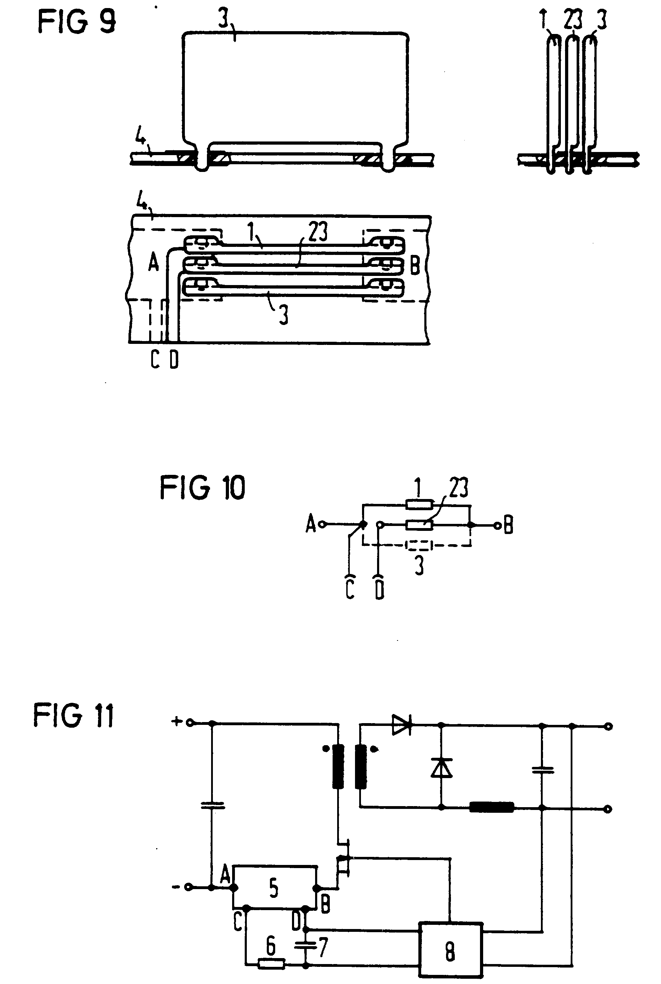

Bei der Anordnung nach Fig. 9 ist die Widerstandsschicht Teil des quaderförmigen, stehend auf der Leiterplatte 4 angeordneten Folienwiderstandes 1. Die Zuleitungsschicht ist Teil des ebenfalls stehend auf einer Leiterplatte 4 angeordneten weiteren Folienwiderstandes 23. Die Rückleitung besteht somit aus einem zusätzlichen Folienwiderstand. Der Widerstandswert des zusätzlichen Folienwiderstandes 23 ist dabei praktisch nicht von Bedeutung, da der zusätzliche Folienwiderstand 23 nur vom Meßstrom durchflossen wird. Wegen der gewünschten Kompensationswirkung ist es vorteilhaft, für beide Folienwiderstände wenigstens näherungsweise die gleiche Bauform zu wählen.

In den Figuren 8 und 10 ist der Folienwiderstand 3 jeweils strichliert dargestellt. Dies bringt zum Ausdruck, daß der Folienwiderstand 3 gegebenenfalls zusätzlich zum Folienwiderstand 1 vorgesehen werden kann. Sind im Hinblick auf eine größere Verlustleistung zwei Folienwiderstände 1 und 3 zu einem Strommeßwiderstand parallel geschaltet, so erfolgt die Rückführung der Meßspannung zweckmäßigerweise zwischen den beiden Folienwiderständen 1 und 3.

Bei den Anordnungen nach Fig. 7 und 9, die jeweils einen zusätzlichen Folienwiderstand 3 vorsehen, fließt der Laststrom je zur Hälfte über die Widerstände 1 und 3 vom Anschluß A zum Anschluß B. Die Meßspannung wird an der Parallelschaltung abgegriffen und zwischen den beiden Strommeßwiderständen bzw. Shunts zurückgeführt. Durch diese Anordnung wird das Stromabbild der Meßspannung deutlich verbessert.

Bei den beiden Ausführungsformen mit Parallelschaltung zweier Folienwiderstände erfolgt entsprechend Fig. 7 über das Blechteil 22 oder entsprechend Fig. 9 über den dritten Folienwiderstand 23. In beiden Fällen ist die Widerstandsschicht Teil der beiden quaderförmigen, stehend auf der Leiterplatte 4 angeordneten Folienwiderstände 1, 3. Die Zuleitungsschicht ist das auf der Leiterplatte 4 zwischen den beiden Folienwiderstände 1, 3 stehend angeordnetes metallenes Blechteil 22 oder eine Widerstandsschicht dritten Folienwiderstandes 23.

Bei dem Folienwiderstand trägt jeweils ein wenigstens an seiner Oberfläche elektrisch isolierender Träger als Widerstandsschicht eine Folie aus einem Widerstandsmaterial.

Fig. 11 zeigt einen Stromlauf eines getakteten Stromversorgungsgerätes mit einer Meßanordnung 5, die Anschlüsse A und B für den im primärseitigen Hauptstromkreis fließenden Strom und Anschlüsse C, D für die gewonnene Meßspannung aufweist. An die Anschlüsse C und D ist der Tiefpaß 6, 7 angeschlossen, der zum Regler 8 führt. Da die Meßanordnung 5 als Meßspannung ein getreues Abbild des Stromes liefert, ergibt sich ein vorteilhaftes Regelverhalten des getakteten Stromversorgungsgerätes.

## Patentansprüche

1. Anordnung zur Gewinnung einer einem zu messenden Strom proportionalen Spannung, mit wenigstens einem Widerstandsbauteil (1, 3), das eine ebene, flächenhafte Widerstandsschicht (10) aufweist und an einander gegenüberliegenden Enden der Widerstandsschicht mit Anschlüssen (A, B) für den Strom versehen ist,
**dadurch gekennzeichnet**,
daß räumlich zum Widerstandsbauteil (1, 3) eine flächenhafte Zuleitungsschicht (21, 22, 23) in der Art angeordnet ist, daß die Längsachse des Widerstandsbauteils (1, 3) und die Längsachse der Zuleitungsschicht (21, 22, 23) parallel verläuften und die flächenhafte Widerstandsschicht des Widerstandsbauteils annähernd deckungsgleich zur Zuleitungsschicht angeordnet ist, daß die Widerstandsschicht (10) und die Zuleitungsschicht (21, 22, 23) an einer ihrer Stirnseiten elektrisch miteinander verbunden sind und an den der elektrischen Verbindung gegenüberliegenden Stirnseiten Anschlüsse (C, D) für die gewonnene Spannung aufweisen.

2. Anordnung nach Anspruch 1,
**dadurch gekennzeichnet,**
daß die Widerstandsschicht (10) Teil eines quaderförmigen, liegend auf der Leiterplatte (4) angeordneten Widerstandsbauteils (1) und die Zuleitungsschicht (21) Teil einer Kaschierung der Leiterplatte (4) ist, die das Widerstandsbauteil (1) trägt.

3. Anordnung nach Anspruch 1,
**dadurch gekennzeichnet,**
daß die Zuleitungsschicht ein Blechteil (22) ist.

4. Anordnung nach Anspruch 3,
**dadurch gekennzeichnet,**
daß die Widerstandsschicht (10) Teil eines quaderförmigen, stehend auf der Leiterplatte (4) angeordneten Widerstandsbauteils (1) ist und daß die Zuleitungsschicht (21) ein ebenfalls stehend auf der Leiterplatte (4) angeordnetes metallenes Blechteil (22) ist.

5. Anordnung nach Anspruch 1,
**dadurch gekennzeichnet,**
daß die Zuleitungsschicht eine weitere Widerstandsschicht (10) ist.

6. Anordnung nach Anspruch 5,
**dadurch gekennzeichnet,**
daß die Widerstandsschicht (10) ein Teil eines quaderförmigen, stehend auf einer Leiterplatte (4) angeordneten Widerstandsbauteiles (1) ist und
daß die Zuleitungsschicht Teil eines ebenfalls stehend auf der Leiterplatte (4) zugeordneten weiteren Widerstandsbauteils (23) ist.

7. Anordnung nach Anspruch 1,
**dadurch gekennzeichnet,**
daß die Widerstandsschicht (10) Teil zweier quaderförmiger, stehend auf einer Leiterplatte (4) angeordneter Widerstandsbauteile (1, 3) und die Zuleitungsschicht ein auf der Leiterplatte (4) zwischen den beiden Widerstandsbauteilen (1, 3) stehend angeordnetes metallenes Blech (22) ist.

8. Anordnung nach Anspruch 1,
**dadurch gekennzeichnet,**
daß die Widerstandsschicht (10) Teil zweier quaderförmiger, stehend auf einer Leiterplatte (4) angeordneter Widerstandsbauteile (1, 3) und die Zuleitungsschicht ein auf der Leiterplatte (4) zwischen den beiden Widerstandsbauteilen (1, 3) stehend angeordnetes weiteres Widerstandsbauteil ist.

## Claims

1. Arrangement for obtaining a voltage which is proportional to a current to be measured, having at least one resistance component (1, 3) which has a flat resistance coating (10) in the form of a sheet and is provided at mutually opposite ends of the resistance coating with connections (A, B) for the current, characterized in that a feed coating (21, 22, 23) in the form of a sheet is arranged physically with respect to the resistance component (1, 3) in such a manner that the longitudinal axis of the resistance component (1, 3) and the longitudinal axis of the feed coating (21, 22, 23) run parallel and the resistance coating, which is in the form of a sheet, of the resistance component is arranged to be approximately superimposed on the feed coating, in that the resistance coating (10) and the feed coating (21, 22, 23) are electrically connected to one another at one of their ends and, at the ends which are opposite the electrical connection, have connections (C, D) for the voltage obtained.

2. Arrangement according to Claim 1, characterized in that the resistance coating (10) is part of a right-parallelepiped resistance component (1) which is arranged horizontally on the printed circuit board (4), and the feed coating (21) is part of a coating on the printed circuit board (4), which carries the resistance component (1).

3. Arrangement according to Claim 1, characterized in that the feed coating is a sheet-metal part (22).

4. Arrangement according to Claim 3, characterized in that the resistance coating (10) is part of a right-parallelepiped resistance component (1) which is arranged vertically on the printed circuit board (4), and in that the feed coating (21) is a metallic sheet-metal part (22) which is likewise arranged vertically on the printed circuit board (4).

5. Arrangement according to Claim 1, characterized in that the feed coating is a further resistance coating (10).

6. Arrangement according to Claim 5, characterized in that the resistance coating (10) is a part of a right-parallelepiped resistance component (1) which is arranged vertically on a printed circuit board (4), and in that the feed coating is part of a further resistance component (23) which is assigned to the printed circuit board (4), likewise vertically.

7. Arrangement according to Claim 1, characterized in that the resistance coating (10) is part of two right-parallelepiped resistance components (1, 3) which are arranged vertically on a printed circuit board (4), and the feed coating is a metallic metal sheet (22) which is arranged vertically on the printed circuit board (4) between the two resistance components (1, 3).

8. Arrangement according to Claim 1, characterized in that the resistance coating (10) is part of two right-parallelepiped resistance components (1, 3) which are arranged vertically on a printed circuit board (4), and the feed coating is a further resistance component which is arranged vertically on the printed circuit board (4) between the two resistance components (1, 3).

## Revendications

1. Dispositif pour obtenir une tension proportionnelle à un courant à mesurer, comportant au moins un composant de résistance (1,3), qui a une couche (10) résistive plane d'une certaine étendue en surface et qui comporte des bornes (A,B) pour le courant, sur des extrémités de la couche résistive en face l'une de l'autre,
caractérisé par le fait qu'une couche d'une certaine étendue en surface (21,22,23) formant conducteur d'alimentation est disposée par rapport au composant de résistance (1,3) dans l'espace de telle sorte que l'axe longitudinal du composant de résistance (1,3) et l'axe longitudinal de la couche (21,22,23) formant conducteur d'alimentation soient parallèles l'un à l'autre et que la couche résistive d'une certaine étendue en surface du composant de résistance soit disposée sensiblement en recouvrement de la couche formant conducteur d'alimentation, la couche résistive (10) et la couche (21,22,23) formant conducteur d'alimentation sont reliées entre elles électriquement par un de leurs côtés frontaux et ont, sur les côtés frontaux en face de la liaison électrique, des bornes (C,D) pour la tension obtenue.

2. Dispositif suivant la revendication 1, caractérisé par le fait que la couche résistive (10) fait partie d'un composant de résistance (1) de forme parallélépipédique, qui est disposé parallèlement à la plaquette à circuits imprimés (4) et que la couche (21) formant conducteur d'alimentation fait partie d'un placage de la plaquette à circuits imprimés (4), qui porte le composant de résistance (1).

3. Dispositif suivant la revendication 1, caractérisé par le fait que la couche formant conducteur d'alimentation est une pièce en tôle (22).

4. Dispositif suivant la revendication 3, caractérisé par le fait que la couche résistive (10) fait partie d'un composant de résistance (1) de forme parallélépipédique, qui est disposé perpendiculairement sur la plaquette à circuits imprimés (4) et la couche (21) formant conducteur d'alimentation est une pièce en tôle métallique (22) également disposée perpendiculairement sur la plaquette à circuits imprimés (4).

5. Dispositif suivant la revendication 1, caractérisé par le fait que la couche formant conducteur d'alimentation est une autre couche résistive (10).

6. Dispositif suivant la revendication 5, caractérisé par le fait
que la couche résistive (10) fait partie d'un composant de résistance (1) de forme parallélépipédique et disposé perpendiculairement sur une plaquette à circuits imprimés (4), et
que la couche formant conducteur d'alimentation fait partie d'un autre composant formant résistance (23), également disposé perpendiculairement sur la plaquette à circuits imprimés (4).

7. Dispositif suivant la revendication 1, caractérisé par le fait que la couche résistive (10) fait partie de deux composants de résistance (1,3), qui ont une forme parallélépipédique et qui sont disposés perpendiculairement sur une plaquette à circuits imprimés (4), et la couche formant conducteur d'alimentation est une tôle métallique (22) disposée perpendiculairement sur la plaquette à circuits imprimés (4) entre les deux composants de résistance (1,3).

8. Dispositif suivant la revendication 1, caractérisé par le fait que la couche résistive (10) fait partie de deux composants de résistance (1,3) de forme parallélépipédique et disposés perpendiculairement sur une plaquette à circuits imprimés (4), et la couche formant conducteur d'alimentation est un autre composant de résistance, qui est disposé sur la plaquette à circuits imprimés (4) entre les deux composants de résistance (1,3).
